# EUROPEAN PATENT APPLICATION

(11) **EP 1 732 210 A1**
(43) Date of publication of application: **13.12.2006**
(21) Application number: 05719383.1
(22) Date of filing: 22.02.2005
(51) Int. Cl.: H03F 3/34, H04B 1/16

(54) **PILOT SIGNAL DETECTING CIRCUIT, AND SEMICONDUCTOR INTEGRATED CIRCUIT INCORPORATING THAT CIRCUIT**

(30) Priority: 09.03.2004 JP 2004066148
(71) Applicant: KABUSHIKI KAISHA TOYOTA JIDOSHOKKI, Kariya-shi, Aichi 448-8671 (JP); Niigata Seimitsu Co., Ltd., Jouetsu-shi, Niigata 943-0834 (JP)
(72) Inventor: KATO, Masaaki, Kariya-shi, Aichi 4488671 (JP); MIYAGI, Hiroshi, NIIGATA SEIMITSU CO., LTD., Joetsu-shi, Niigata 9430834 (JP)
(74) Representative: Leson, Thomas Johannes Alois
(86) International application number: PCT/JP2005/002808
(87) International publication number: WO 2005/086344

(57) **Abstract**

The purpose of the present invention is to improve a detection accuracy of a pilot signal detection circuit. A pilot detection signal voltage is input to a differential amplifier circuit 16 and a reference voltage generated by a reference signal generation circuit 17 is input to a differential amplifier circuit 19. A pilot signal is compared with the reference voltage by the differential amplifier circuits 16 and 19. Output currents of the differential amplifier circuits 16 and 19 are converted into voltages by a current-to-voltage conversion circuit 21. And an input to the current-to-voltage conversion circuit 21 is fed back with a voltage proportionate with an offset voltage of the circuit and the offset voltage of the pilot signal detection circuit is cancelled.

## Description

### Field of the Invention

The present invention relates to a pilot detection circuit for an FM receiver and a semiconductor integrated circuit equipping the circuit.

### Background of the Invention

An FM receiver detects a level of a pilot signal included in a stereo complex signal and changes over between a stereo receiving and monaural receiving based on the detection result.

The pilot signal detection circuit for example comprises a phase wave detector circuit, smoothing circuit, comparator circuit, et cetera, so that the comparator circuit compares whether or not the smoothed pilot signal is equal to a reference value or greater.

When comparing the pilot signal with the reference voltage, an offset cancellation circuit is equipped for removing an influence of an offset voltage occurring in the inside of a detection circuit.

A patent document 1 has noted a technique for charging and discharging a capacitor intermittently in order to make the capacitance a capacitor of a smoothing circuit of a pilot detection circuit small.

And a patent document 2 has noted on a CMOS band gap reference voltage generation circuit which is immune to an influence of a power supply voltage fluctuation.

In the meantime, since a reference voltage of a comparator circuit of a pilot signal detection circuit is varied by a fluctuation of power supply voltage, temperature changes, et cetera, an accurate detection of pilot signal levels has been difficult. And in the case of constituting a pilot signal detection circuit by a MOS transistor, there has been a problem of an offset voltage occurring in the inside of the circuit becoming large because a mismatching in the characteristics of the MOS transistors is relatively large, sometimes requiring a work for adjusting the offset for the pilot detection circuit.
[Patent document 1] laid-open Japanese patent application publication No. 2003-152666 (Figs. 2 and 3)
[Patent document 2] laid-open Japanese patent application publication No. 2000-222054 (paragraph 0015)

### Summary of the Invention

The challenge of the present invention is to improve a detection accuracy of a pilot detection circuit.

A pilot signal detection circuit according to the present invention comprises: a first semiconductor switch for outputting by selecting either a base-band signal or a predetermined voltage; a detection circuit for detecting a signal output from the first semiconductor switch; a smoothing circuit for smoothing an output signal of the detection circuit; a first differential amplifier circuit for differential-amplifying an output signal of the smoothing circuit; a band gap reference voltage generation circuit for generating a reference voltage; a second semiconductor switch for outputting by selecting either the reference voltage output from the band gap reference voltage generation circuit or the predetermined voltage; a second differential amplifier circuit for differential-amplifying a signal output from the second semiconductor switch; and an offset removal circuit for retaining outputs of the first and second differential amplifier circuits as an offset cancellation voltage when the predetermined voltage is selected by the first and second semiconductor switches, and removing an offset voltage included in the signals output from the first and second differential amplifier circuit based on the offset cancellation voltage.

The present invention makes it possible to set a pilot signal level and a reference voltage level independently by inputting the base band signal and the reference voltage into respectively different differential amplifier circuits (i.e., the first and second differential amplifier circuits).

And, it is possible to remove the offset voltage of the entirety of the pilot signal detection circuit including the detection circuit and the smoothing circuit by equipping the semiconductor switch at the front stage of the detection circuit and the smoothing circuit, supplying the first differential amplifier circuit with the base band signal and the predetermined voltage by changing over, retaining output voltages of the first and second differential amplifier circuit as the offset cancellation voltage when supplying the predetermined voltage and canceling the offset voltage based on the offset cancellation voltage. This makes it possible to improve a detection accuracy of the pilot signal detection circuit.

Furthermore, it is possible to generate the reference voltage with a good temperature characteristic by using a bipolar transistor formed on a MOS integrated circuit board, for example, for the band gap reference voltage generation circuit. This enables a more accurate detection of a pilot signal level.

Another pilot signal detection circuit according to the present invention comprises : a first semiconductor switch for outputting by selecting either a base-band signal or a predetermined voltage; a detection circuit for detecting a signal output from the first semiconductor switch; a smoothing circuit for smoothing an output signal of the detection circuit; a first differential amplifier circuit for differential-amplifying an output signal of the smoothing circuit; a band gap reference voltage generation circuit for generating a reference voltage; a second semiconductor switch for outputting by selecting either the reference voltage output from the band gap reference voltage generation circuit or the predetermined voltage; a second differential amplifier circuit for differential-amplifying a signal output from the second semiconductor switch; a current-to-voltage conversion circuit for converting an output current of the first differential amplifier circuit and that of the second differential amplifier circuit into respective voltages; and an offset removal circuit for retaining an output voltage of the current-to-voltage conversion circuit as an offset cancellation voltage when the predetermined voltage is selected by the first and second semiconductor switch and removing an offset voltage by feeding the retained offset cancellation voltage back to an input to the current-to-voltage conversion circuit.

The present invention makes it possible to set a pilot signal level and a reference voltage level independently by inputting the base band signal and the reference voltage into respectively different differential amplifier circuits (i.e., the first and second differential amplifier circuits).

Furthermore, it is possible to detect an offset voltage of the entirety of the pilot signal detection circuit including the detection circuit and the smoothing circuit by equipping the first semiconductor switch at the front stage of the detection circuit and smoothing circuit, supplying the detection circuit with the base band signal and the predetermined voltage by changing over and detecting an output voltage of the current-to-voltage conversion circuit when supplying the predetermined voltage. And it is possible to remove then offset voltage of the entirety of the pilot signal detection circuit including the detection circuit and the smoothing circuit by feeding the detected voltage back to the input to the current-to-voltage conversion circuit as the offset cancellation voltage. This configuration eliminates a necessity of equipping an offset removal circuit for the detection circuit or smoothing circuit, hence making the configuration of the pilot signal detection circuit simple.

And use of a band gap voltage as the reference voltage improves the detection accuracy of the pilot signal level.

According to another aspect of the present invention, the smoothing circuit comprises a capacitor, and a third semiconductor switch which becomes an on-state when the first semiconductor switch selects the base band signal for charging the capacitor with an output voltage of the smoothing circuit, while becomes an off-state when the first semiconductor switch selects the predetermined voltage for retaining a voltage of the capacitor, in the above described invention.

Such a configuration charges the capacitor with a voltage smoothed by the smoothing circuit when the base band signal is input to the detection circuit; while cuts the capacitor off the smoothing circuit by turning off the third semiconductor switch when the predetermined voltage is supplied to the detection circuit. This configuration prevents the offset voltage from being influenced by the pilot signal voltage which is retained by the capacitor.

According to another aspect of the present invention, the reference voltage generation circuit generates the reference voltage by using a bipolar transistor which is formed on a MOS integrated circuit board, in the above described invention.

Such a configuration enables an improvement of a temperature characteristic of the reference voltage by using a band gap voltage of the bipolar transistor as the reference.

According to yet another aspect of the present invention, the offset removal circuit comprises a fourth semiconductor switch which becomes an on-state when the first semiconductor switch selects the predetermined voltage, otherwise becoming an off-state, a capacitor for retaining output voltages of the first and second differential amplifier circuits or an output voltage of the current-to-voltage conversion circuit as an offset cancellation voltage, and a third differential amplifier circuit for removing the offset voltage by feeding the offset cancellation voltage retained by the capacitor back to either the output of the first and second differential amplifier circuit or the input to the current-to-voltage conversion circuit, in the above described invention.

Such a configuration enables a removal of the offset voltage being generated in the inside of the pilot signal detection circuit.

A semiconductor integrated circuit according to the present invention forms, on a semiconductor integrated circuit board by a MOS process, a pilot signal detection circuit which comprises: a detection circuit for detecting a base band signal; a smoothing circuit for smoothing an output signal of the detection circuit; a first differential amplifier circuit for differential-amplifying an output signal of the smoothing circuit; a band gap reference voltage generation circuit for generating a reference voltage; a second differential amplifier circuit for differential-amplifying the reference voltage; and an output circuit for outputting a signal of a sum of outputs of the first and second differential amplifier circuits as a signal for indicating whether or not a pilot signal level is equal to, or greater than, a reference voltage.

According to the present invention, it is possible to set the pilot signal level and the reference voltage level independently by inputting the base band signal and the reference voltage to the respectively different differential amplifier circuits (i.e., the first and second differential amplifier circuits).

### Brief Description of Drawings

Fig. 1 is a block diagram of a pilot signal detection circuit according to the embodiment;
Fig. 2 is a circuit diagram of the main part of a pilot detection circuit; and
Fig. 3 is a circuit diagram of a band gap reference voltage generation circuit.

### Detailed Description of the Preferred Embodiments

The following is a detailed description of the preferred embodiment of the present invention while referring to the accompanying drawings. The present invention comprises as described in the following.

A pilot signal detection circuit according to the present invention comprises: a first semiconductor switch for outputting by selecting either a base-band signal or a predetermined voltage; a detection circuit for detecting a signal output from the first semiconductor switch; a smoothing circuit for smoothing an output signal of the detection circuit; a first differential amplifier circuit for differential-amplifying an output signal of the smoothing circuit; a band gap reference voltage generation circuit for generating a reference voltage; a second semiconductor switch for outputting by selecting either the reference voltage output from the band gap reference voltage generation circuit or the predetermined voltage; a second differential amplifier circuit for differential-amplifying a signal output from the second semiconductor switch; and an offset removal circuit for retaining outputs of the first and second differential amplifier circuits as an offset cancellation voltage when the predetermined voltage is selected by the first and second semiconductor switch, and removing an offset voltage included in a signal output from the first and second differential amplifier circuit based on the offset cancellation voltage.

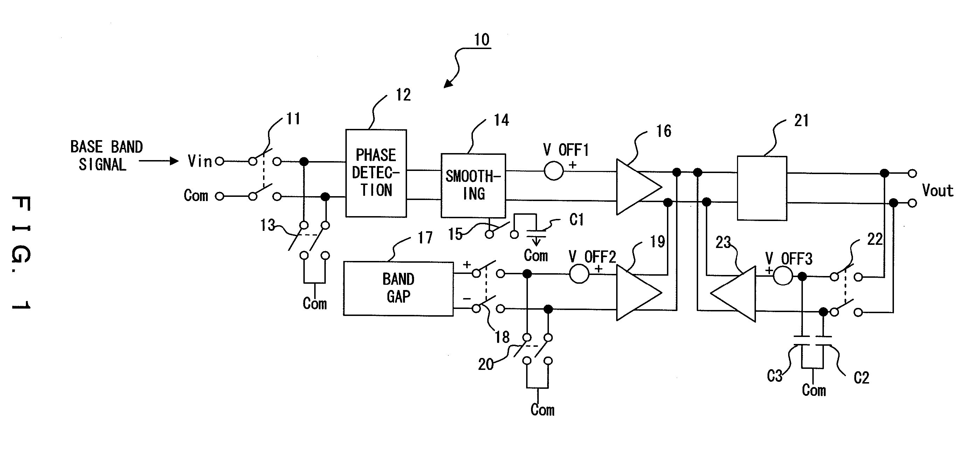

The first semiconductor switch corresponds to semiconductor switches 11 and 13 shown by Fig. 1 for example and the first differential amplifier circuit corresponds to a differential amplifier circuit 16 shown by Fig. 1. And the second semiconductor switch corresponds to semiconductor switches 18 and 20 shown by Fig. 1, and the second differential amplifier circuit corresponds to a differential amplifier circuit 19 shown by Fig. 1.

According to another aspect of the present invention, the offset removal circuit comprises a fourth semiconductor switch which becomes an on-state when the first and second semiconductor switches select the predetermined voltage, otherwise becoming an off-state, a capacitor for retaining output voltages of the first and second differential amplifier circuits or the output voltage of the current-to-voltage conversion circuit as the offset cancellation voltage, and a third differential amplifier circuit for removing the offset voltage by feeding the offset cancellation voltage retained by the capacitor back to either the output of the first and second differential amplifier circuit or the input to the current-to-voltage conversion circuit.

The fourth semiconductor switch corresponds to a semiconductor switch 22 shown by Fig. 1 for example, and the capacitor corresponds to capacitors C2 and C3 shown by Fig. 1.

Fig. 1 is a block diagram of a pilot signal detection circuit 10 according to the embodiment of the present invention. Note that the pilot signal detection circuit 10 according to the embodiment is equipped onto a semiconductor integrated circuit board, for use in an FM & AM radio receiver, produced by a CMOS process capable of featuring a p-channel MOS transistor and n-channel MOS transistor.

Referring to Fig. 1, the two semiconductor switches turn on or off by linking together in the semiconductor switch 11, with an input terminal to one thereof being input by a base band signal (e.g., a stereo complex signal, et cetera), an input terminal to the other semiconductor switch 11 being input by a predetermined voltage Com and the two output terminal being connected to a phase detection circuit 12. The semiconductor switch 11 is constituted by a transfer gate, et cetera. Note that the predetermined voltage Com is a reference voltage generated within the semiconductor circuit, a discretionary voltage as a result of dividing the reference voltage, or a ground voltage.

The two semiconductor switches turn on or off by linking together in a semiconductor switch 13, with two input terminal being input by a predetermined voltage Com and two output terminal being connected to the phase detection circuit 12.

When sampling a pilot signal, a control signal is supplied from a control signal generation unit (not shown herein) for turning the semiconductor switch 11 on and turning the semiconductor switch 13 off, and a base band signal is supplied to the phase detection circuit 12. Meanwhile, at an offset canceling, a control signal is supplied for turning the semiconductor switch 11 off and turning the semiconductor switch 13 on, and a predetermined voltage Com is supplied to the phase detection circuit 12.

The phase detection circuit 12 detects a base band signal at a timing synchronously with the phase of a pilot signal and outputs the detection output to a smoothing circuit 14.

The smoothing circuit 14 smoothes an output signal of the phase detection circuit 12 for outputting to the differential amplifier circuit 16. An output terminal of the smoothing circuit 14 is connected by the semiconductor switch 15 and capacitor C1 serially.

The semiconductor switch 15 is provided by the same control signal as the semiconductor switch 11 so as to turn it on when the semiconductor switch 11 is turned on and charges the capacitor C1 with a voltage of a pilot signal smoothed by the smoothing circuit 14. Then, when detecting an offset voltage, the semiconductor switch 11 is turned off so that the pilot signal voltage retained by the capacitor C1 does not influence the offset voltage.

The differential amplifier circuit 16 amplifies the pilot signal voltage smoothed by the smoothing circuit 14 for outputting to a current-to-voltage conversion circuit 21. An offset voltage VOFF1 on a non-inverted input side of the differential amplifier circuit 16 is an offset voltage on the output side, which is generated by a mismatching of characteristics of CMOS transistors of the phase detection circuit 12, smoothing circuit 14 and differential amplifier circuit 16, converted into a voltage on the input side. When applying the offset voltage VOFF1 to the input side with a state of an input signal being zero, a voltage output from the differential amplifier circuit 16 becomes the same as the total of offset voltages generating in the inside of the phase detection circuit 12, smoothing circuit 14 and differential amplifier circuit 16.

A reference voltage generation circuit (i.e., a band gap reference voltage generation circuit) 17 is the one for generating with a band gap voltage of a bipolar transistor as the reference voltage, thus outputting a reference voltage as the base for comparing a pilot signal level.

A semiconductor switch 18 outputs an output of the reference voltage generation circuit 17 to the differential amplifier circuit 19 selectively by turning the two semiconductor switches on or off by linking them together. The semiconductor switch 18 is provided by the same control signal as the semiconductor switch 11 and therefore the semiconductor switch 18 turns on when the semiconductor switch 11 turns on, and the semiconductor switch 18 turns off when the semiconductor switch 11 turns off.

A semiconductor switch 20 outputs a predetermined voltage Com to the differential amplifier circuit 19 selectively by turning two semiconductor switches on or off by linking them together. The semiconductor switch 20 is provided by the same control signal as the semiconductor switch 13 and therefore the semiconductor switch 20 turns on when the semiconductor switch 13 turns on, and vice versa.

The differential amplifier circuit 19 amplifies the reference voltage or the predetermined voltage for outputting to the current-to-voltage conversion circuit 21 according to a selection of the semiconductor switches 18 and 20. An offset voltage VOFF2 on the non-inverted input side of the differential amplifier circuit 19 is a voltage converted into the one on the input side of an offset voltage on the output side which is generated by a mismatching of characteristics of MOS transistor of the differential amplifier circuit 19.

The current-to-voltage conversion circuit 21 is the one for converting differential output currents, into voltages, of the differential amplifier circuit 16 and differential amplifier circuit 19. The output of the current-to-voltage conversion circuit 21 is output to an output circuit comprising an inverter (not shown herein), et cetera.

A semiconductor switch 22 outputs an output of the current-to-voltage conversion circuit 21 to the capacitors C2 and C3, and differential amplifier circuit 23 selectively by turning two semiconductor switches on or off by linking them together. Incidentally, the semiconductor switch 22 is provided by the same control signal as the semiconductor switch 13. The other terminals of the capacitors C2 and C3 are connected to the predetermined voltage Com.

A differential amplifier circuit 23 cancels an offset voltage of the entirety of the pilot signal detection circuit 10 by feeding an offset cancellation voltage retained by the capacitors C2 and C3 back to an input to the current-to-voltage conversion circuit 21. An offset voltage VOFF3 on the non-inverted input side of the differential amplifier circuit 23 is a voltage converted into the one on the input side of an offset voltage on the output side which is generated by a mismatching of characteristics of MOS transistors of the differential amplifier circuit 23.

The above described semiconductor switch 22, capacitors C2 and C3, and differential amplifier circuit 23, constitute an offset removal circuit.

When turning on the semiconductor switch 13 so as to supply the phase detection circuit 12 with the predetermined voltage Com, the capacitors C2 and C3 are charged with a voltage (i.e., an offset voltage on the entirety of the pilot signal detection circuit) output from the current-to-voltage conversion circuit 21.

As the semiconductor switch 11 is turned on at every predetermined sampling cycle for supplying the phase detection circuit 12 with a pilot signal, an offset cancellation signal retained by the capacitors C2 and C3 is fed back to the input side of the current-to-voltage conversion circuit 21, thereby canceling the offset voltage of the entire circuit.

The next description is of an operation of the pilot signal detection circuit 10 configured as described above. The first description deals with the case of sampling a pilot signal, that is, the semiconductor switches 11, 15 and 18 being turned on, while the semiconductor switches 13, 20 and 22 being turned off.

In this event, a base band signal is synchronously detected in the phase detection circuit 12 to extract a pilot signal. Then the pilot signal is smoothed to a DC voltage by the smoothing circuit 14 followed by the DC voltage being amplified by the differential amplifier circuit 16. In this event, the semiconductor switch 15 is turned on and the capacitor C1 is charged with the sampled pilot signal voltage.

As the semiconductor switch 18 is turned on and the semiconductor switch 20 is turned off, the reference voltage output from the reference voltage generation circuit 17 is amplified by the differential amplifier circuit 19.

The output currents of the differential amplifier circuits 16 and 19 are converted into voltages by the current-to-voltage conversion circuit 21 and output as a signal for indicating a judgment result of a pilot signal.

The next description is of the time of detecting an offset voltage, that is, the event of the semiconductor switches 13, 20 and 22 being turned on while the semiconductor switches 11, 15 and 18 being turned off.

In this event, a predetermined voltage Com is supplied to two inputs to the phase detection circuit 12 and an offset voltage being generated in the phase detection circuit 12, smoothing circuit 14 and differential amplifier circuit 16 is output from the differential amplifier circuit 16.

In this event, the semiconductor switch 15 is turned off, hence retaining a pilot signal voltage charged in the capacitor C1.

And, since the semiconductor switch 20 is turned on and the semiconductor switch 18 is turned off, a predetermined voltage Com is input to the two input terminals of the differential amplifier circuit 19 and accordingly an offset voltage generating in the differential amplifier circuit 19 is output.

In this case, a differential input voltage to the differential amplifier circuits 16 and 19 is the same predetermined voltage Com, and therefore the output voltage of the current-to-voltage conversion circuit 21 becomes an offset voltage of the entire circuit with the base band signal being zero. In this event, since the semiconductor switch 22 is turned on, the charged voltage in the capacitors C2 and C3 becomes the total voltage of offset voltages being generated in the phase detection circuit 12, smoothing circuit 14, differential amplifier circuit 16, differential amplifier circuit 19, differential amplifier circuit 23 and current-to-voltage conversion circuit 21.

When becoming the next sampling timing following the pilot signal, the semiconductor switches 11, 15 and 18 being turned on and the semiconductor switches 13, 20 and 22 being turned off so that a base band signal is synchronously detected in the phase detection circuit 12 for detecting a pilot signal which is then smoothed and amplified by the differential amplifier circuit 16.

Then, an offset cancellation voltage (i.e., an offset voltage of the entire circuit) charged in the capacitors C2 and C3 is negatively fed back to the input side of the current-to-voltage conversion circuit 21 by the differential amplifier circuit 23, thereby canceling an offset voltage generating within the pilot signal detection circuit 10.

The pilot signal detection circuit 10 according to the embodiment uses two differential amplifier circuits 16 and 19 for inputting a pilot signal voltage and referent voltage to the respectively different input terminals of the differential amplifier circuits 16 and 19, thereby making it possible to set a voltage level of the pilot signal relative to the ground voltage and that of the reference voltage relative to the ground voltage independently. This enables a use of a band gap voltage of a bipolar transistor featuring on a MOS integrated circuit board as the reference voltage, hence improving a detection accuracy of a pilot signal level.

In the case of using the band gap voltage of the bipolar transistor which is featured on the MOS integrated circuit board, the collector of the bipolar transistor becomes the lowest voltage of the board and therefore the reference voltage of the reference voltage generation circuit 17 becomes the lowest voltage of the board. Because of this, a level of the reference voltage is limited. The present embodiment uses two differential amplifier circuits 16 and 19, there by making it possible to set a level of the reference voltage independently of that of the pilot signal voltage. By this, the band gap voltage of the bipolar transistor on the MOS integrated circuit can be used as the reference voltage.

And supplying the phase detection circuit 12 with the base band signal and the predetermined voltage Com by changing over by the semiconductor switch 11 enables detection of the offset voltage of the entirety of the pilot signal detection circuit including the phase detection circuit 12, smoothing circuit 14 and differential amplifier circuits 16, 19, 23, et cetera. This makes it possible to eliminate the offset voltage of the entirety of the pilot signal detection circuit including the phase detection circuit 12 and smoothing circuit 14 and therefore improve a detection accuracy of the pilot signal. And a work for adjusting an offset removal circuit of the pilot signal detection circuit 10 is no longer required. Moreover, there is no longer a necessity of equipping an offset removal circuit for the phase detection circuit 12 and smoothing circuit 14, hence simplifying the circuit structure from the standpoint of the pilot signal detection circuit 10 as a whole.

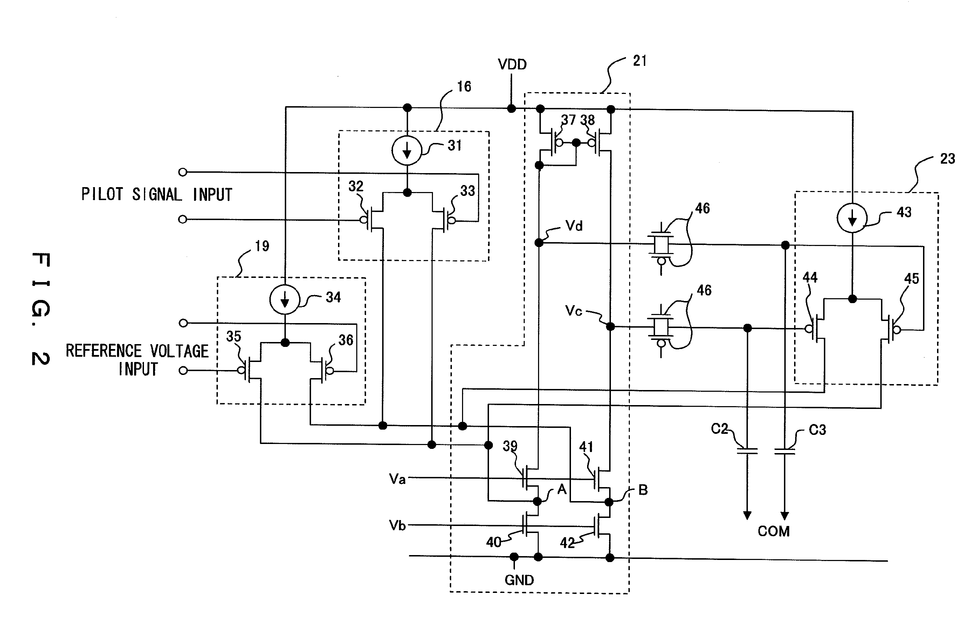

Next, Fig. 2 exemplifies a concrete circuit diagram of a pilot detection circuit 10. The differential amplifier circuit 16 comprises a constant current power supply 31, which is connected to a power supply VDD on the one end, and differentially connected p-channel MOS transistors 32 and 33 whose source is connected to an output side of the constant current power supply 31. The gates of the p-channel MOS transistors 32 and 33 are input by the pilot signal or the predetermined voltage Com which are smoothed by the smoothing circuit 14.

The drain of the p-channel MOS transistor 33 is connected to the connection point A of the current-to-voltage conversion circuit 21, while the drain of the p-channel MOS transistor 32 is connected to the connection point B of the current-to-voltage conversion circuit 21. The constant current power supply 31 is constituted by a current mirror circuit, et cetera.

The differential amplifier circuit 19 comprises a constant current power supply 34, which is connected to a power supply VDD on the one end, and differentially connected p-channel MOS transistors 35 and 36 whose source is connected to an output side of the constant current power supply 34. The gates of the p-channel MOS transistors 35 and 36 are connected by the reference voltage or the predetermined voltage Com which are output from the reference voltage generation circuit 17.

The drain of the p-channel MOS transistor 35 is connected to the connection point A of the current-to-voltage conversion circuit 21, while the drain of the p-channel MOS transistor 36 is connected to the connection point B of the current-to-voltage conversion circuit 21.

The current-to-voltage conversion circuit 21 comprises p-channel MOS transistors 37 and 38 which constitute a current mirror circuit, n-channel MOS transistors 39 and 40 which are cascade-connected to the p-channel MOS transistor 37, and n-channel MOS transistors 41 and 42 which are cascade-connected to the p-channel MOS transistor 38.

The connection point A between the n-channel MOS transistors 39 and 40, and the connection point B between the n-channel MOS transistors 41 and 42 are input by the output currents of the differential amplifier circuits 16 and 19.

The gates of the n-channel MOS transistors 39 and 41 are provided by a common gate voltage Va, that of the n-channel MOS transistors 40 and 42 are provided by a common gate voltage Vb, and the sources of the MOS transistors 40 and 42 are grounded.

The differential amplifier circuit 23 comprises a constant current power supply 43, which is connected to the power supply VDD on the one end, and differentially connected p-channel MOS transistors 44 and 45 whose sources are connected to the output side of the constant current power supply 43.

The gate of the p-channel MOS transistor 44 is connected to the capacitor C2 and the drain of the p-channel MOS transistor 38 by way of a transfer gate 46 (i.e., a semiconductor switch 22). The gate of the p-channel MOS transistor 45 is connected to the capacitor C3 and the drain of the p-channel MOS transistor 37 by way of transfer gate 46. The transfer gate 46 is constituted by connecting a p-channel MOS transistor and n-channel MOS transistor in parallel.

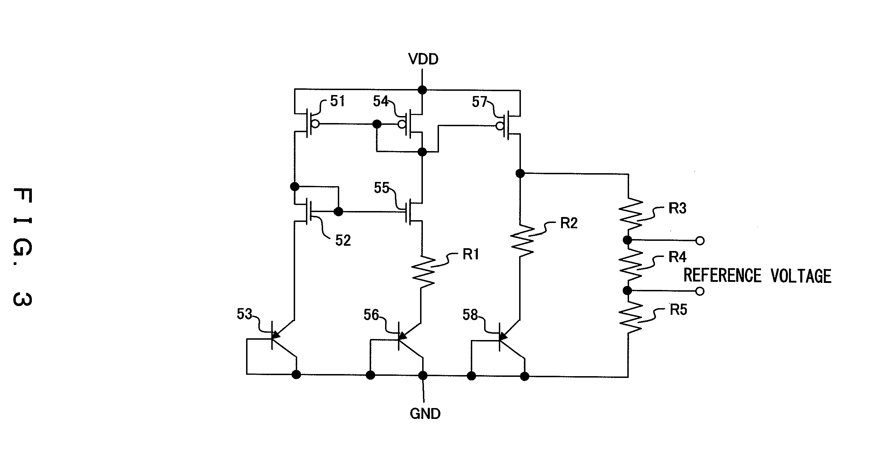

The next description is of an operation of a circuit which is configured as described above. Considering the case of the pilot signal voltage output from the smoothing circuit 14 being equal to the reference voltage as basis, if the pilot voltage becomes smaller than the reference voltage, an output current of the differential amplifier circuit 16 to which the pilot signal and the reversed phase signal are input, that is, of the MOS transistor 33 increases, and accordingly the current flowing to the connection point A between the MOS transistors 39 and 40 on the left side (by looking at the front of Fig. 3 of the current-to-voltage conversion circuit 21 increases.

While the current flowing from the transistor 33 to the connection point A increases, the current flowing into the transistor 40 stays the same, resulting in the current flowing to the transistor 39 decreasing and the drain current of the transistor 37 decreasing. As the drain current of the transistor 37 decreases, the drain current of the transistor 38 also decreases and therefore the voltage Vd at the drain part (i.e., a voltage with the grounding as reference) of the transistors 37 and 39 increase.

On the other hand, the output current of the transistor 32 decreases as much as the amount of increase in the output current of the transistor 33. While the current flowing from the transistor 32 into the connection point B decreases, the current flowing in the transistor 42 stays the same, resulting in increasing the current flowing in the transistor 41 and also increasing the drain current of the transistor 38. As the drain current of the transistor 38 increases, the voltage Vc at the drain part of the transistors 38 and 41 decreases.

As a result of the above, the differential voltage between the output voltage of the current-to-voltage conversion circuit 21, that is, the voltage Vd at the drain part of the MOS transistor 37, and the voltage Vc at the drain part of the MOS transistor 38 becomes large.

Comparably to the above, as the pilot signal voltage becomes larger than the reference voltage, the output current of the MOS transistor 33 of the differential amplifier circuit 16 decreases and the current flowing into the connection point A between the MOS transistors 39 and 40 on the left side of the current-to-voltage conversion circuit 21 decreases.

As a result of the current flowing to the connection point A decreasing, the drain current of the MOS transistor 37 increases and at the same time the current of the MOS transistor 38 on the right side of the current mirror circuit increases.

On the other hand, the output current of the transistor 32 increases as much as that of the transistor 33 decreases, resulting in the current flowing to the connection point B increasing. As a result of the current flowing to the connection point B increasing, the drain current of the transistor 41 decreases.

As a result of the above, the differential voltage between the output voltage of the current-to-voltage conversion circuit 21, that is, the voltage Vd at the drain part of the MOS transistor 37 and the voltage Vc at the drain part of the MOS transistor 38 becomes small. The change in the output voltage of the current-to-voltage conversion circuit 21 can be converted to a high level and low level signals by an output circuit such as an inverter.

In other words, if the pilot signal voltage is smaller than the reference voltage, the output voltage of the current-to-voltage conversion circuit 21 becomes larger than the voltage at the time of the pilot signal voltage being equal to the reference voltage, while if the pilot signal voltage is larger than the reference voltage, the output voltage of the current-to-voltage conversion circuit 21 becomes small. Therefore, it is possible to judge whether or not the pilot signal is equal to, or greater than, the reference voltage by the output voltage of the current-to-voltage conversion circuit 21.

Next, Fig. 3 exemplifies a band gap reference voltage generation circuit 17.

Referring to Fig. 3, a p-channel MOS transistor 51, n-channel MOS transistor 52 and bipolar transistor 53 are serially connected between the power supply VDD and the ground. The base and collector of the bipolar transistor 53 is grounded (at the lowest voltage on the integrated circuit board).

Likewise, p-channel MOS transistor 54, n-channel MOS transistor 55, resistor R1 and bipolar transistor 56 are serially connected between the power supply VDD and the ground. The base and collector of the bipolar transistor 56 are grounded.

The gate of the n-channel MOS transistor 52 is connected to the drain, and further connected to the gate of the n-channel MOS transistor 55 so as to constitute a current mirror circuit.

The p-channel MOS transistor 57, resistor R2 and bipolar transistor 58 are connected between the power supply VDD and the ground. The base and collector of the bipolar transistor 58 are grounded.

Furthermore, resistors R3, R4 and R5 are serially connected in parallel with the resistor R2 and bipolar transistor 58 so that the voltage across the resistor R4 is output as the reference voltage.

In the circuit shown by Fig. 3, a current proportionate with the absolute temperature is generated by the MOS transistors 51 and 54, MOS transistors 52 and 55, bipolar transistors 53 and 56, and resistor R1. And the current is flowing to the MOS transistor 57, thus the voltage across the resistor R2 holding a positive thermal coefficient proportionately with the absolute temperature.

In the meantime, the voltage Vbe between the base and emitter of the bipolar transistor 58 has a negative thermal coefficient, therefore the sum of the both voltages becomes constant vis-à-vis temperature.

Accordingly, the reference voltage independent of a temperature can be obtained by dividing the voltage across the resistor R2 by the resistors R3, R4 and R5.

The present invention makes it possible to set a pilot signal level and the reference voltage level independently by inputting the base band signal and the reference voltage into the respectively different differential amplifier circuits (i.e., the first and second differential amplifier circuits). And the offset voltage of the entirety of the pilot signal detection circuit including the detection circuit, the smoothing circuit and the differential amplifier circuit can be detected by supplying the detection circuit with the base band signal and the predetermined voltage by changing over by a semiconductor switch. This makes it possible to eliminate the offset voltage of the entirety of the pilot signal detection circuit including the detection circuit, the smoothing circuit and the differential amplifier circuit, thereby improving a detection accuracy of the pilot signal detection circuit.

In stead of being limited by the above described embodiment, the present invention may be configured as follows:
(1) The differential amplifier circuits 16, 19 and 23 may use other known differential amplifier circuits, such as a power output type differential amplifier circuit, in lieu of being limited by the circuit shown by the embodiment.
(2) In the case of using a power output type differential amplifier circuit, a circuit configuration may use no current-to-voltage conversion circuit.

## Claims

1. A pilot signal detection circuit, comprising:
a first semiconductor switch for outputting by selecting either a base-band signal or a predetermined voltage;
a detection circuit for detecting a signal output from the first semiconductor switch;
a smoothing circuit for smoothing an output signal of the detection circuit;
a first differential amplifier circuit for differential-amplifying an output signal of the smoothing circuit;
a band gap reference voltage generation circuit for generating a reference voltage;
a second semiconductor switch for outputting by selecting either the reference voltage output from the band gap reference voltage generation circuit or the predetermined voltage;
a second differential amplifier circuit for differential-amplifying a signal output from the second semiconductor switch; and
an offset removal circuit for retaining outputs of the first and second differential amplifier circuits as an offset cancellation voltage when the predetermined voltage is selected by the first and second semiconductor switch, and removing an offset voltage included in a signal output from the first and second differential amplifier circuit based on the offset cancellation voltage.

2. A pilot signal detection circuit, comprising:
a first semiconductor switch for outputting by selecting either a base-band signal or a predetermined voltage;
a detection circuit for detecting a signal output from the first semiconductor switch;
a smoothing circuit for smoothing an output signal of the detection circuit;
a first differential amplifier circuit for differential-amplifying an output signal of the smoothing circuit;
a band gap reference voltage generation circuit for generating a reference voltage;
a second semiconductor switch for outputting by selecting either the reference voltage output from the band gap reference voltage generation circuit or the predetermined voltage;
a second differential amplifier circuit for differential-amplifying a signal output from the second semiconductor switch;
a current-to-voltage conversion circuit for converting an output current of the first differential amplifier circuit and a output current of the second differential amplifier circuit into respective voltages; and
an offset removal circuit for retaining an output voltage of the current-to-voltage conversion circuit as an offset cancellation voltage when the predetermined voltage is selected by the first and second semiconductor switch and removing an offset voltage by feeding the retained offset cancellation voltage back to an input of the current-to-voltage conversion circuit.

3. The pilot signal detection circuit according to claims 1 or 2, wherein
said smoothing circuit comprises a capacitor, and
a third semiconductor switch which becomes an on-state when said first semiconductor switch selects the base band signal for charging the capacitor with an output voltage of the smoothing circuit, while becomes an off-state when the first semiconductor switch selects the predetermined voltage for retaining a voltage of the capacitor.

4. The pilot signal detection circuit according to claims 1 or 2, wherein
said band gap reference voltage generation circuit generates the reference voltage by using a bipolar transistor formed on a MOS integrated circuit board.

5. The pilot signal detection circuit according to claims 1 or 2, wherein
said offset removal circuit comprises:
a fourth semiconductor switch which becomes an on-state when said first semiconductor switch selects said predetermined voltage, otherwise becoming an off-state,
a capacitor for retaining output voltages of said first and second differential amplifier circuits or an output voltage of said current-to-voltage conversion circuit as an offset cancellation voltage, and
a third differential amplifier circuit for removing an offset voltage by feeding the offset cancellation voltage retained by the capacitor back to either the output of the first and second differential amplifier circuit or the input to the current-to-voltage conversion circuit.

6. The pilot signal detection circuit according to claims 1 or 2, wherein
said detection circuit is a phase detection circuit for carrying out a phase detection of a pilot signal of a stereo complex signal.

7. A semiconductor integrated circuit forming, on a semiconductor integrated circuit board by a MOS process, a pilot signal detection circuit which comprises:
a detection circuit for detecting a base band signal;
a smoothing circuit for smoothing an output signal of the detection circuit;
a first differential amplifier circuit for differential-amplifying an output signal of the smoothing circuit;
a band gap reference voltage generation circuit for generating a reference voltage;
a second differential amplifier circuit for differential-amplifying the reference voltage; and
an output circuit for outputting a signal of a sum of outputs of the first and second differential amplifier circuits as a signal for indicating whether or not a pilot signal level is equal to, or greater than, the reference voltage.

8. A semiconductor integrated circuit, forming, on a semiconductor integrated circuit board by a MOS process, a pilot signal detection circuit which comprises:
a detection circuit for detecting a signal output from the first semiconductor switch;
a smoothing circuit for smoothing an output signal of the phase circuit;
a first differential amplifier circuit for differential-amplifying an output signal of the smoothing circuit;
a reference voltage generation circuit for generating a reference voltage;
a second semiconductor switch for outputting by selecting either the reference voltage output from the reference voltage generation circuit or the predetermined voltage;
a second differential amplifier circuit for differential-amplifying a signal output from the second semiconductor switch; and
an offset removal circuit for retaining outputs of the first and second differential amplifier circuits as an offset cancellation voltage when the predetermined voltage is selected by the first and second semiconductor switch, and removing an offset voltage included in a signal output from the first and second differential amplifier circuit based on the offset cancellation voltage.

9. The semiconductor integrated circuit according to claim 8, wherein
said smoothing circuit comprises
a capacitor, and
a third semiconductor switch which becomes an on-state when said first semiconductor switch selects the base band signal for charging the capacitor with the output voltage of the smoothing circuit, while becomes an off-state when the first semiconductor switch selects the predeterminedvoltage for retaining a voltage of the capacitor.
